(19) Europäisches Patentamt
European Patent Office
Office européen des brevets

(11) **EP 2 181 465 B1**

(12) **EUROPÄISCHE PATENTSCHRIFT**

(45) Veröffentlichungstag und Bekanntmachung des Hinweises auf die Patenterteilung:
**24.04.2013 Patentblatt 2013/17**

(21) Anmeldenummer: **08802652.1**

(22) Anmeldetag: **26.09.2008**

(51) Int Cl.:
**H01L 29/94** (2006.01)    **H01L 35/32** (2006.01)
**H01L 35/00** (2006.01)

(86) Internationale Anmeldenummer:
**PCT/EP2008/008200**

(87) Internationale Veröffentlichungsnummer:
**WO 2009/052920 (30.04.2009 Gazette 2009/18)**

(54) **THERMOELEKTRISCHER GENERATOR**

THERMOELECTRIC GENERATOR

GENERATEUR THERMOELECTRIQUE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **22.10.2007 DE 102007050741**

(43) Veröffentlichungstag der Anmeldung:
**05.05.2010 Patentblatt 2010/18**

(73) Patentinhaber: **O-Flexx Technologies GmbH**
**47059 Duisburg (DE)**

(72) Erfinder: **BISGES, Michael**
**93161 Sinzig (DE)**

(74) Vertreter: **Kohlmann, Kai**
**Donatusstraße 1**
**52078 Aachen (DE)**

(56) Entgegenhaltungen:
**EP-A1- 1 287 566    EP-A1- 1 326 292**

- SANDOMIRSKY V ET AL: "Electric-field-effect thermoelectrics" JOURNAL OF APPLIED PHYSICS, AMERICAN INSTITUTE OF PHYSICS. NEW YORK, US, Bd. 90, Nr. 5, 1. September 2001 (2001-09-01), Seiten 2370-2379, XP012054066 ISSN: 0021-8979

- SANDOMIRSKY V ET AL: "The physics of electric field effect thermoelectric devices" MATERIALS RESEARCH SOCIETY SYMPOSIUM PROCEEDINGS - FERROELECTRIC THIN FILMS IX. SYMPOSIUM, Bd. 655, 2001, Seiten CC11.13.1-CC11.13.6, XP002531760 MATER. RES. SOC WARRENDALE, PA, USA ISBN: 1-55899-565-X

- SANDOMIRSKY V ET AL: "Electric field effect controlled thermoelectricity in thin Bi films" PHYSICA B ELSEVIER NETHERLANDS, Bd. 329-333, 11. Mai 2003 (2003-05-11), Seiten 1521-1522, XP002531761 ISSN: 0921-4526

- HASEGAWA Y ET AL: "Magneto-Seebeck coefficient of a bismuth microwire array in a magnetic field" APPLIED PHYSICS LETTERS, AIP, AMERICAN INSTITUTE OF PHYSICS, MELVILLE, NY, US, Bd. 85, Nr. 6, 1. Januar 2004 (2004-01-01), Seiten 917-919, XP012064179 ISSN: 0003-6951

- HAMABE M ET AL: "Magnetic field effect for improvement of thermoelectric conversion: a proposal for nernst-seebeck element" THERMOELECTRICS, 2003 TWENTY-SECOND INTERNATIONAL CONFERENCE ON - ICT LA GRANDE MOTTE, FRANCE AUG. 17-21, 2003, PISCATAWAY, NJ, USA,IEEE, 17. August 2003 (2003-08-17), Seiten 567-570, XP010697377 ISBN: 978-0-7803-8301-2

EP 2 181 465 B1

**Beschreibung**

Die Erfindung betrifft einen thermoelektrischen Generator mit mindestens einer ersten Leiter-Schicht aus thermoelektrisch aktivem Material, einem lateralen Temperaturgradienten parallel (x-Richtung) zur Oberfläche des thermoelektrischen Materials sowie mindestens zwei selektiven Kontakten zum Abführen des von dem Generator erzeugten elektrischen Stroms.

Die direkte Wandlung von Wärme in elektrische Energie ist mit einem thermoelektrischen Generator möglich. Man verwendet hierfür vorzugsweise unterschiedlich dotierte Halbleitermaterialien, wodurch sich die Effizienz gegenüber Thermoelementen mit zwei unterschiedlichen und an einem Ende miteinander verbundenen Metallen, wesentlich steigern lässt. Heute verfügbare thermoelektrische Generatoren haben dennoch nur einen verhältnismäßig geringen Wirkungsgrad. Gebräuchliche Halbleitermaterialien sind Bi2Te3, PbTe, SiGe, BiSb oder FeSi2 mit Wirkungsgraden zwischen 3% und 8%. Um ausreichend hohe Spannungen zu erhalten, werden mehrere thermoelektrische Generatoren elektrisch in Reihe geschaltet.

Ein als thermoelektrischer Generator betriebenes Thermoelement besteht üblicherweise aus zwei dünnen wärmeleitenden, insbesondere keramischen Platten zwischen denen abwechselnd kleine Quader aus unterschiedlich dotiertem Halbleitermaterial angeordnet sind. Jeweils zwei unterschiedliche Quader sind so miteinander verbunden, dass sie eine elektrische Reihenschaltung ergeben. Eine der beiden Platten nimmt den einfließenden Wärmestrom auf (nachfolgend auch als heiße Seite des thermoelektrischen Generators bezeichnet), während die andere Platte den ausfließenden Wärmestrom abgibt(nachfolgend auch als kalte Seite des thermoelektrischen Generators bezeichnet). Alle Quader werden parallel vom Wärmestrom, der von der heißen zur kalten Seite fließt durchströmt.

Die Wirkungsweise der thermoelektrischen Generatoren beruht auf dem thermoelektrischen Effekt, nachfolgend als Seebeck-Effekt bezeichnet. Beim Seebeck-Effekt entsteht zwischen zwei Punkten eines elektrischen Leiters bzw. Halbleiters, die eine verschiedene Temperatur haben, eine elektrische Spannung. Die Spannung entsteht durch Thermodiffusionsströme: Ein elektrischer Leiter weist freie Elektronen und positiv geladenen Atomrümpfe auf. Eine bestimmte Temperatur bewirkt, dass sich die im Material gespeicherte thermische Energie auf die Bewegungsenergie der Elektronen und die Schwingungsenergie der Atomrümpfe aufteilt. Das Verhältnis ist hierbei eine für das jeweilige Material typische Konstante. Folglich besitzen die Elektronen am heißen Ende eine höhere Bewegungsenergie als die Elektronen am kalten Ende des Leiters bzw. Halbleiters. Die größere Bewegungsenergie bewirkt nun, dass sich die "heißen" Elektronen im Leiter stärker verteilen als die "kalten", was zu einem Ungleichgewicht führt, da die Elektronendichte am kalten Ende zunimmt. Dies geschieht genau so lange, bis die durch dieses Ungleichgewicht aufgebaute elektrische Spannung dafür sorgt, dass ein gleich großer Strom "kalter" Elektronen auf die heiße Seite fließt. Die entstehende Spannung ist bestimmt durch:

$$U_{\text{Seebeck}} = \alpha \cdot \Delta T$$

mit

$\Delta T$     Temperaturdifferenz zwischen den Leiter-/ Halbleiterenden bzw. den Kontaktstellen

$\alpha$     Seebeck-Koeffizient oder so genannte "Thermokraft"

Der Seebeck-Koeffizient hat die Dimension einer elektrischen Spannung pro Temperaturdifferenz (V/K). Die entstehende Spannung ist unabhängig von der Umgebungstemperatur und lediglich von der Temperaturdifferenz der Kontaktstellen abhängig.

Der Seebeck-Effekt beschreibt ausschließlich die Entstehung dieser Spannung. Ein durch äußere Beschaltung entstehender Stromfluss zwischen den Kontaktstellen ist nicht Teil dieses Effektes und folgt lediglich aus dem Ohmschen Gesetz.

Aus SANDOMIRSKY, V., u. a.: Electric-field-effect thermoelectrics. In: Journal of Applied Physics, 2001, Vol. 90, No. 5, Seiten 2370 - 2379 ist eine thermoelektrische Struktur bekannt, die eine erste Leiterschicht aus thermoelektrisch aktivem Halbleitermaterial aufweist, einen lateralen Temperaturgradienten parallel zur Oberfläche des thermoelektrischen Materials (x-Richtung) sowie eine Steuerelektrodenschicht, die von dem Halbleitermaterial durch ein Dielektrikum getrennt ist.

Ein hoher Wirkungsgrad des thermoelektrischen Generators wird in einem Material mit hohem Seebeck-Koeffizient bei gleichzeitig niedrigem spezifischem Widerstand und niedriger Wärmeleitfähigkeit erreicht. Diese für die Thermoelektrizität wichtigen Eigenschaften eines Materials lassen sich nur in sehr geringem Maße unabhängig voneinander beeinflussen. Um den Wirkungsgrad eines thermoelektrischen Generators zu steigern, wird in der EP 1 287 566 B1 ein thermnelektrisches Element mit mindestens einer n-Schicht und mindestens einer p-Schicht eines dotierten Halbleiters vorgeschlagen, wobei die n- und die p-Schicht unter Ausbildung eines pn-Übergangs angeordnet sind. Die n- und die p-Schicht sind elektrisch selektiv kontaktiert. Parallel zur Grenzschicht zwischen den n- und p-Schichten ist ein Temperaturgradient angelegt. Der pn-Übergang ist im Wesentlichen entlang der gesamten, vorzugsweise längsten Ausdehnung der n-Schicht und der p-Schicht und damit im Wesentlichen entlang deren gesamter Grenzschicht ausgebildet. Durch den Temperaturgradienten entlang der großflächigen pn-Grenzfläche entsteht ein Temperaturunterschied entlang dieses länglich ausgebildeten pn-Übergangs zwischen zwei Enden eines pn-Schichtpakets, der dazu führt, dass der Wirkungsgrad des thermoelektrischen Elementes höher ist als beim Stand der Technik, der keinen Temperaturgradienten entlang und innerhalb des pn-Übergangs aufweist. Die selektive Kontaktierung der n- und p-Schicht erfolgt entweder durch Einlegieren der Kontakte und den damit verbundenen pn-Übergängen oder durch eine direkte Kontaktierung der einzelnen Schichten. Die selektiven Kontakte sind separate, nicht miteinander in leitender Verbindung stehende Kontakte, die an den p- und n-Schichten angeordnet sind.

Ausgehend von diesem Stand der Technik liegt der Erfindung die Aufgabe zu Grunde, einen thermoelektrischen Generator der eingangs erwähnten Art zu schaffen, der einen weiter verbesserten Wirkungsgrad aufweist.

Die Lösung basiert auf dem Gedanken, die Thermodiffusionsströme mit einem äußeren elektrischen Feld zu beeinflussen, um den Wirkungsgrad des thermoelektrischen Generators zu verbessern.

Im Einzelnen wird die Aufgabe bei einem thermoelektrischen Generator der eingangs erwähnten Art dadurch gelöst, dass

- der thermoelektrische Generator Mittel zur Erzeugung eines quer zur Stromflussrichtung des thermoelektrischen Generators anliegenden elektrischen Feldes aufweist,
- der thermoelektrische Generator mehrere Leiter-Schichten aus thermoelektrisch aktivem Material aufweist, wobei aneinandergrenzende Leiter-Schichten unterschiedliche thermoelektrische Materialien aufweisen und das elektrische Feld sich zumindest bis in die erste Leiter-Scricht hinein erstreckt und
- dass die Mittel jeweils eine elektrisch leitfähige Steuerelektroden-Schicht umfassen, die auf beiden nach außen weisenden Oberflächen der aneinandergrenzenden Leiter-Schichten angeordnet ist.

Mit Hilfe des Feldes lässt sich der Seebeck-Koeffizient verändern, insbesondere auch erhöhen. Bei unterstelltem gleich bleibenden lateralen Temperaturgradienten zwischen den beiden selektiven Kontakten zum Abführen des von dem Generator erzeugten Stroms tritt bei unverändertem spezifischen Widerstand eine erhöhte Seebeckspannung auf. Mit Hilfe des elektrischen Feldes lässt sich die energetische Verteilung der Ladungsträger durch die Ausbildung von Verarmungs- und Anreicherungszonen verändern. Insbesondere lässt sich die Elektronendichte an der kalten Seite des thermoelektrischen Materials durch Ausrichtung erhöhen, so dass sich der Stromfluss zwischen der kalten und heißen Seite zwischen den selektiven Kontakten des Generators erhöht.

Der laterale Temperaturgradient parallel zur Oberfläche des thermoelektrischen Materials wird erzeugt, in dem mit einer Stirnseite der Leiter-Schicht eine Wärmequelle und mit der gegenüberliegenden Stirnseite der Leiter-Schicht eine Wärmesenke, beispielsweise ein Kühlkörper, mit dem thermoelektrischen Generator in Kontakt gebracht wird. Durch die Temperaturdifferenz zwischen den beiden Stirnseiten des thermoelektrischen Generators ergibt sich ein Wärmestrom von der heißen zur kalten Seite des Generators.

Erfindungsgemäß weist der thermoelektrische Generator mehrere Leiter-Schichten aus thermoelektrisch aktivem Material auf, die zu einem Schichtpaket miteinander verbunden sind, wobei aneinandergrenzende Leiter-Schichten unterschiedliche thermoelektrische Materialien aufweisen, insbesondere unterschiedlich dotierte Halbleitermaterialen, und sich das elektrische Feld zumindest bis in die erste Leiterschicht hinein erstreckt. Durch diese Maßnahme wird ein pn-Übergang im Wesentlichen über die gesamte Erstreckung der Leiterschichten ausgebildet, wobei der Temperaturgradient entlang der pn-Grenzfläche wirksam wird. Hierdurch entsteht ein Temperaturunterschied entlang des pn-Übergangs, der dazu führt, dass der Wirkungsgrad des erfindungsgemäßen thermoelektrischen Generators noch einmal gesteigert wird. Die Wirkungsweise beruht auf der verschiedenen Ausbildung von Potentialmodulationen in einem pn-Übergang bei unterschiedlichen Temperaturen. Wie auch das elektrische Feld beeinflusst der Temperaturgradient die energetische Verteilung der Ladungsträger in dem pn-Übergang zwischen den Leiter-Schichten. Hieraus folgt eine Veränderung der Potentialmodulation:

Die Potentialmodulaticn beschreibt eine Modulation des Potentials für Ladungsträger in Halbleiterstrukturen. So befindet sich ein Elektron energetisch auf einem höheren Potential in der p-Schicht als in der n-Schicht. Für Defektelektronen (Löcher) ist es umgekehrt, wobei die Differenz dieser beiden Potentiale die Potentialmodulation ist. Da für jede Temperatur ein Gleichgewichtswert für die Potentialmodulation existiert, kommt es zur Veränderungen der Potentialmodulation, wenn sich die Temperatur entlang des Temperaturgradienten verändert. Durch den Temperaturgradienten parallel zur Grenzschicht zwischen n- und p-Schicht kommt es daher zu einem Aufbau eines lateralen Potentialgradienten, der in Folge dessen zu einer ambipolaren Ladungsträgerdiffusion und damit zu Ausgleichströmen führt.

Indem jeweils eine elektrisch leitfähige Steuerelektroden-Schicht auf beiden nach außen weisenden Oberflächen der aneinander grenzenden Leiter-Schichten angeordnet ist, lässt sich die Wirkung des elektrischen Feldes in dem Schichtpaket der Leiter-Schichten steigern. Vorzugsweise breitet sich das elektrische Feld über sämtliche Leiter-Schichten aus.

Die Mittel zum Erzeugen des elektrischen Feldes umfassen die elektrisch leitfähige Steuerelektroden-Schicht, die den überwiegenden Teil der Oberfläche der ersten Leiter-Schicht aus thermoelektrisch aktivem Material abdeckt. Die großflächige Abdeckung der Leiter-Schicht bewirkt einen möglichst großen Einfluss der Steuerelektrode auf die Leiter-Schicht aus thermoelektrisch aktivem Material.

In dem die selektiven Kontakte auf verschiedenen aneinander grenzenden Leiterschichten in Bereichen mit unterschiedlichen Temperaturen angeordnet sind, lässt sich ein Stromfluss über die Grenzschicht zwischen den Leiterschichten, insbesondere den pn-Übergang erzwingen. Es wird bei einem Schichtpakt aus Leiter-Schichten jedoch auch dann noch eine Wirkungsgradsteigerung durch das Schicht-Paket erreicht, wenn die selektiven Kontakte auf einer der Leiterschichten in Bereichen mit unterschiedlichen Temperaturen angeordnet sind.

Wenn die Steuerelektrodenschicht und die angrenzende Leiter-Schicht aus unterschiedlich dotierten Halbleitermaterialien bestehen, wobei eine der beiden Schichten eine p-Schicht und eine der beiden Schichten eine n-Schicht eines pn-Übergangs entlang der Grenzschicht zwischen der Steuerelektroden- und der angrenzenden Leiterschicht ausbilden, kann die Steuerelektrode unmittelbar auf der angrenzenden Leiter-Schicht ausgebildet werden. Die Sperrwirkung des pn-Übergangs ermöglicht die Ausbildung des elektrischen Feldes in der bzw. in den Leiter-Schichten aus Halbleitermaterialien.

Die Steuerelektrodenschicht kann auch aus Metall bestehen und unmittelbar auf der angrenzenden Leiter-Schicht aus Halbleitermaterial aufgebracht werden. Hierdurch wird ein so genannter Schottky-Kontakt mit der typischen Metall-Halbleitercharakteristik ausgebildet. Der Halbleiter-Metallübergang des Schottky-Kontaktes wirkt vergleichbar wie ein pn-Übergang zwischen zwei Halbleitern und entfaltet ebenfalls die gewünschte Sperrwirkung in Richtung der Steuerelektroden-Schicht, die zur Ausbildung des elektrischen Feldes erforderlich ist.

Sofern auch die Leiter-Schichten aus metallischen, thermoelektrisch aktiven Materialien bestehen, muss zwischen der elektrisch leitfähigen Steuerelektroden-Schicht und der Leiter-Schicht eine elektrisch isolierende Schicht angeordnet sein.

Durch Anordnung der Stromversorgungs-Kontakte im Abstand voneinander an der Steuerelektroden-Schicht kann ein Stromfluss in der Steuerelektrode parallel zur Stromflussrichtung des thermoelektrischen Generators erzeugt werden, der um die Steuerelektrode herum ein elektromagnetisches Feld ausbildet, das die Bewegung der Ladungsträger in Stromflussrichtung des thermoelektrischen Generators unterstützt.

Wenn die Steuerelektrode aus einzelnen schichtförmigen Segmenten besteht und sich leitfähige und nichtleitfähige Segmente auf der Oberfläche des thermoelektrischen Materials abwechseln, lässt sich die Feldgeometrie des von der Steuerelektrode erzeugten elektrischen Feldes verändern.

Weitere Vorteile und Einzelheiten der Erfindung werden anhand der nachfolgenden Figuren näher erläutert.

Es zeigen:

Figur 1a)     eine schematische Darstellung eines ersten Ausführungsbeispieles eines erfindungsgemäßen thermoelektrischen Generators,

Figur 1b)     eine schematische Darstellung eines weiteren Ausführungsbeispiels eines thermoelektrischen Generators mit schematischer Darstellung der Feldlinien sowie der Stromflussrichtung,

Figur 2a)     einen thermoelektrischen Generator mit lediglich einer Halbleiterschicht aus thermoelektrisch aktivem Material,

Figur 2b)     einen thermoelektrischen Generator mit zwei unterschiedlich dotierten Halbleiterschichten und einer Steuerelektrode,

Figur 2c)     einen thermoelektrischen Generator mit zwei unterschiedlich dotierten Halbleiter-Schichten sowie zwei Steuerelektroden,

Figur 2d)     einen thermoelektrischen Generator entsprechend Figur 2a) jedoch ohne Isolation zwischen Halbleiter-Schicht und Steuerelektrode,

Figur 3a)     einen thermoelektrischen Generator mit zwei unterschiedlich dotierten Halbleiterschichten sowie stromführender Steuerelektrode,

Figur 3b)     Darstellung eines sich um eine Steuerelektrode eines thermoelektrischen Generators aufbauenden elektrischen Feldes,

**Figuren 4 a)-c)**    eine schematische Darstellung zur Erläuterungder Funktionsweise eines thermoelektrischenGenerators mit zwei Steuerelektroden-Schichtensowie einer dazwischen angeordneten Leiter-Schicht,

**Figuren 5a),b)**    eine weitere schematische Darstellung zur Erläuterung der Funktionsweise eines thermoelektrischen Generators gem. Figur 4a) sowie

**Figur 6**    eine schematische Darstellung zur Veranschaulichung der Elektron-/Lochgeneration.

Es haben sich einige Legierungen durch ihre Eigenschaften bei bestimmten Temperaturen als Thermopaare durchgesetzt und sich somit eine Palette von Thermomaterialkombinationen (Thermopaare) über einen Temperaturbereich von -270°C bis 2600°C gebildet. Diese Palette wurde in Normen erfasst und definiert. Die derzeit gültige internationale Norm für Thermoelemente ist die IEC 584-1, das Pendant im deutschsprachigen Raum die DIN EN 60584 Teil 1. Diese Norm definiert 10 verschiedene Thermomaterialkombination in ihren Eigenschaften.

| Typ/Kennbuchstabe | Legierung |
|---|---|
| K | Nickel-Chrom / Nickel-Aluminium |
| T | Kupfer / Kupfer-Nickel |
| J | Eisen / Kupfer-Nickel |
| N | Nickel-Chrom-Silizium / Nickel-Silizium |
| E | Nickel-Chrom / Kupfer-Nickel |
| R | Platin-13%Rhodium / Platin |
| S | Platin-10%Rhodium / Platin |
| B | Platin-30%Rhodium / Platin |

Als leitfähige Materialien für Thermopaare von Thermoelementen kommen jedoch insbesondere p- und n-dotierte Halbleitermaterialen, meist Wismut-Tellurit, $Bi_2Te_3$ in Betracht. Außerdem kommen die in den nachfolgenden Tabellen 1.1. und 1.2 genannten p- und n-dotierten Verbindungen in Betracht:

**Tabelle 1.1:** Die p-Typ Verbindungen mit den besten thermoelektrischen Eigenschaften.

| T [K] | Verbindung p-Typ | Z [1/K] |
|---|---|---|
| 225 | $CsBi_4Te_6 : SbI_3(0,05\%)$ | $3,5 \cdot 10^{-3}$ |
| 300 | $(Sb_2Te_3)_{72}Bi_2Te_3)_{25}(Sb_2Se_3$ | $3,4 \cdot 10^{-3}$ |
| 500 | $Tl_9BiTe_6$ | $2,3 \cdot 10^{-3}$ |
| 700 | $GeTe_{1-x}(AgSbTe_2)_x$ | $3,0 \cdot 10^{-3}$ |
| 1200 | $Si_{0,95}Ge_{0,15} : B$ | $6,7 \cdot 10^{-4}$ |

**Tabelle 1.2:** die n-Typ Verbindungen mit den besten thermoelektrischen Eigenschaften.

| T [K] | Verbindung n-Typ | Z [1/K] |
|---|---|---|
| 80 | $Bi_{0,83}Sb_{0,15}$ | $6,5 \cdot 10^{-3}$ |
| 300 | $((Sb_2Te_3)_5Bi_2Te_3)_{90}(Sb_2 Se_3)_5$ | $3,2 \cdot 10^{-3}$ |
| 450 | $Bi_2Te_{2,7}Se_{0,3}$ | $2,8 \cdot 10^{-3}$ |
| 800 | $Pb_{0,75}Sn_{0,25}Se$ | $>1,25 \cdot 10^{-3}$ |
| 1200 | $Si_{0,85}Ge_{0,15} : P$ | $8,3 \cdot 10^{-4}$ |

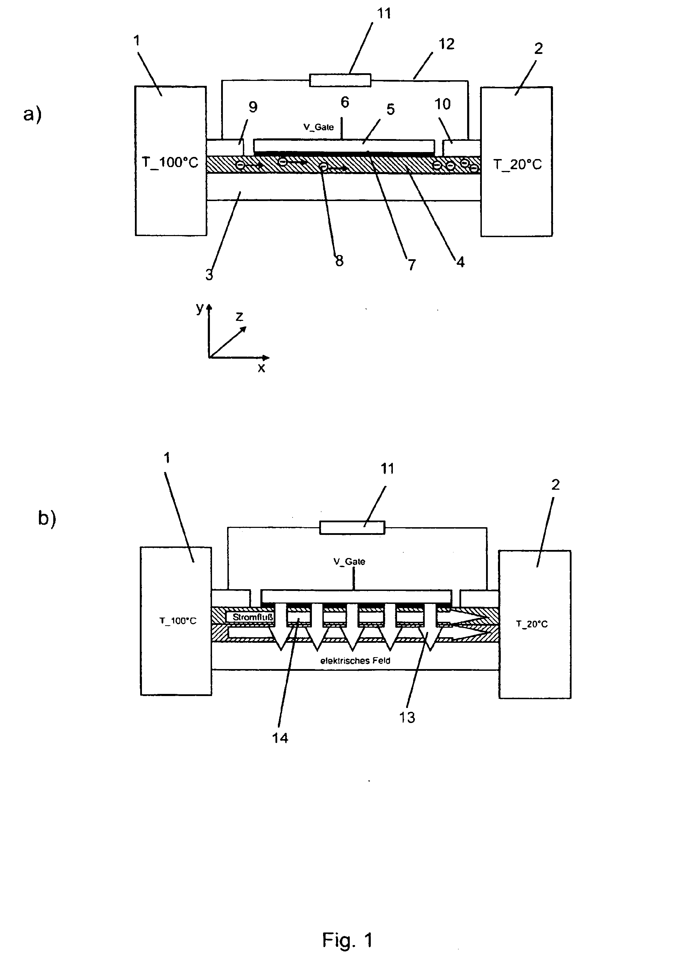

Fig.1 a) zeigt den grundsätzlichen Aufbau einen thermoelektrischen Generators gemäß der Erfindung, allerdings der Übersichtlichkeit halber nur mit einer Halbleiterschicht des Schichtpaketes und einer Steuerelektrodenschicht, wobei auf einem Substrat (3) aus Kunststoff, Metall, Keramik oder Glas eine Halbleiterschicht (4) aufgebracht ist. Auf der Halbleiterschicht (4) sind eine elektrisch isolierende Schicht (7), z.B. aus Keramik oder Glas, und darüber eine elektrisch leitfähige Steuerelektrode (5) als Gate mit einem elektrischen Anschluss (6) aufgebracht. Die Steuerelektrode (5) deckt die Halbleiterschicht (4) großflächig ab, um einen möglichst großen Einfluss der Steuerelektrode (5) auf die Halbleiterschicht (4)zu erzielen.

Im Betrieb wird der thermoelektrische Generator mit einem Temperaturgradienten beaufschlagt, indem auf einer Stirnseite eine Wärmequelle (1), z.B. eine Heizplatte und auf der gegenüberliegenden Stirnseite eine Wärmesenke (2), z.B. ein Kühlkörper mit dem thermoelektrischen Generator in Kontakt gebracht wird. Durch die Temperaturdifferenz zwischen den beiden Stirnseiten des thermoelektrischen Generators ergibt sich ein Wärmestrom von der heißen zu kalten Seite des Generators. Gleichzeitig entsteht durch den Seebeck-Effekt eine Spannung in der Halbleiterschicht (4) die zu einem Stromfluss (8) führt. Die Seebeck-Spannung kann zwischen zwei Kontaktelektroden (9,10) auf der Halbleiterschicht abgegriffen werden. Schließt man den Stromkreis (12) zwischen diesen beiden Kontakten so ist der thermoelektrische Generator im Betriebszustand und kann z.B. einen ohmschen Verbraucher (11) versorgen.

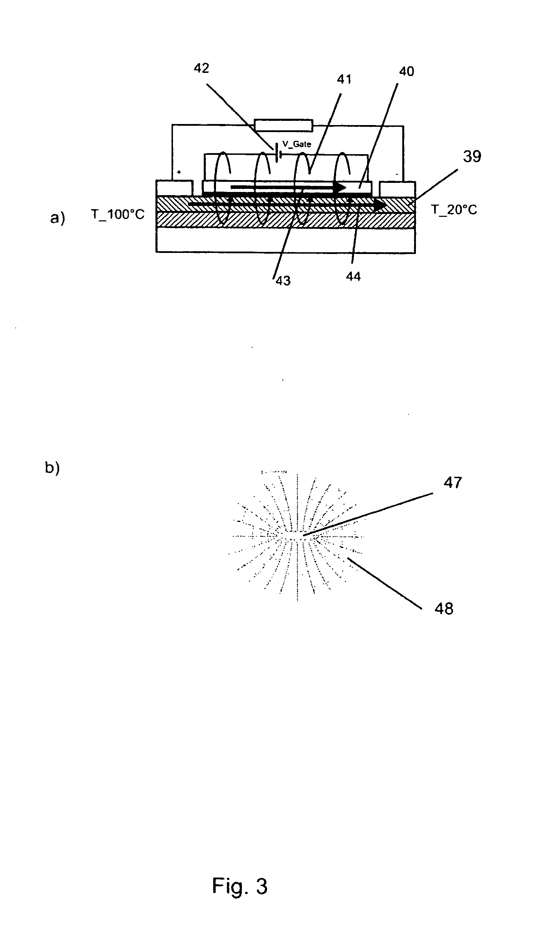

Fig.1 b) zeigt eine schematische Darstellung des thermisch generierten Stromflusses (14) in der/den Halbleiterschicht(en) sowie des elektrischen Feldes (13), das durch die Steuerelektrode (5) aufgebaut wird. Die Elektronen bewegen sich hierbei durch die Seebeck-Spannung im Generator von der heißen zur kalten Seite. Das elektrische Feld (13) bildet sich von der Steuerelektrode aus, wobei das Potential senkrecht zur Steuerelektrode abnimmt und die Äquipotentiallinien annähernd parallel zur Steuerelektrode verlaufen (siehe Fig.3b). Insofern stehen das elektrische Feld (13) und die Bewegungsrichtung der Elektronen senkrecht zueinander.

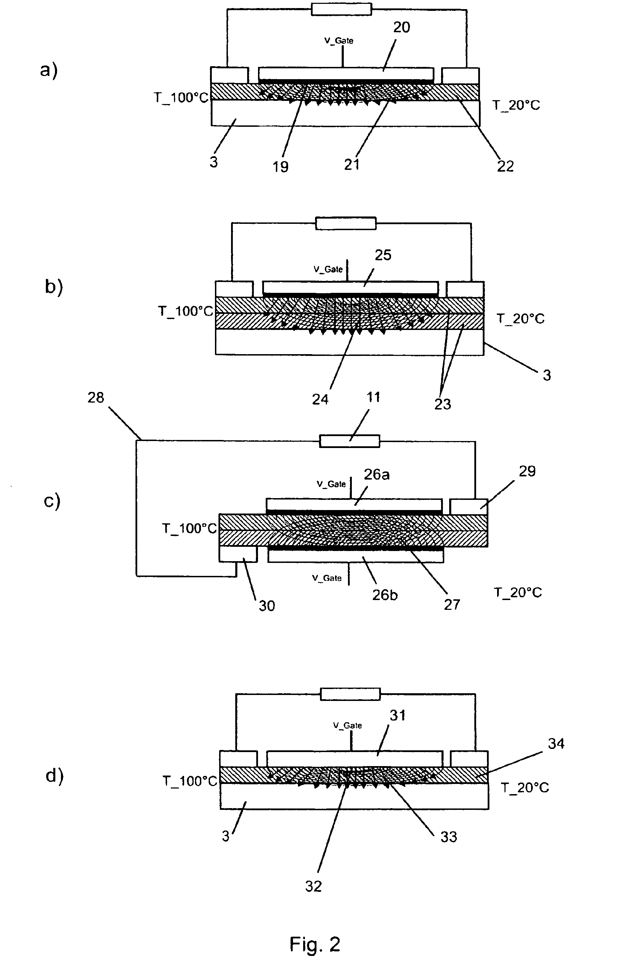

Fig. 2 a) zeigt einen thermoelektrischen Generator mit der Darstellung lediglich der ersten Halbleiterschicht (22) als thermoelektrisch aktives Material. Hierbei können sowohl n-als auch p-dotierte Halbleiter-Materialien eingesetzt werden. Diese Materialien unterscheiden sich allerdings in der Diffusionsbewegung der Elektronen und Löcher. Im p-dotierten Halbleiter diffundieren vorwiegend Löcher von der heißen zur kalten Seite. Im n-dotierten Halbleiter diffundieren vorwiegend Elektronen von der heißen zur kalten Seite. Mit der Steuerelektrode (20) und einer daran anliegenden Spannung (V_Gate) wird ein elektrisches Feld (21) erzeugt, dessen Feldlinien senkrecht zur Bewegungsrichtung der Elektronen stehen. Die Elektronen und Löcher bewegen sich dabei vorwiegend parallel zur Ausbildung jeder Halbleiterschicht (22), da die Schicht im Verhältnis zur Schichtdicke (0,01-1000$\mu$m) lang gestreckt ausgebildet ist (1-100mm). Zwischen der Steuerelektrode (20) und der Halbleiterschicht (22) ist eine elektrisch isolierende Schicht (19) angeordnet.

Fig. 2 b) zeigt einen thermoelektrischen Generator mit mehreren unterschiedlich dotierten Halbleiterschichten (23). Das von der Steuerelektrode (25) ausgehende elektrische Feld (24) breitet sich dabei über mindestens eine der Halbleiterschichten, vorzugsweise beide Halbleiterschichten (23) und über den p-n-Übergang aus.

Fig. 2 c) zeigt einen erfindungsgemäßen thermoelektrischen Generator mit beidseitiger Steuerelektrode (26 a,b), mehreren Halbleiterschichten sowie selektiven elektrischen Kontakten (29,30) auf den beiden Halbleiterschichten, wobei jeweils einer der Kontakte (29) am kalten Ende des thermoelektrischen Generators und einer der Kontakte (30) am heißen Ende des thermoelektrischen Generators angeordnet ist. Die sich überlagernden elektrischen Felder der oberen und unteren Steuerelektroden (26a, 26b) sind mit der Positionsziffer (27) gekennzeichnet. An den elektrischen Kontakten (29,30) ist über eine Verbindungsleitung (28) ein ohmscher Verbraucher (11) angeschlossen.

Fig. 2 d) zeigt einen thermoelektrischen Generator mit der Darstellung lediglich der ersten Halbleiterschicht (34), einer Steuerelektrode (31) ohne Isolationsschicht zwischen Halbleiterschicht (34) und Steuerelektrode (31), wobei die Grenzfläche (32) zwischen der Steuerelektrode (31) sowohl als Schottky-Kontakt als auch als p-/n-Übergang ausgebildet sein kann. Wird die Steuerelektrode (31) aus einem Metall gebildet, entsteht ein Schottky-Kontakt mit der typischen Metall-Halbleiter Charakteristik. Alternativ kann die Steuerelektrode (31) auch aus einem Halbleitermaterial bestehen, das in Kombination mit der Halbleiterschicht (34) einen pn-Übergang ausbildet. Bei beiden Kombinationen erzeugt eine an der Steuerelektrode (31) anliegende elektrische Spannung ein elektrisches Feld, das sich in die Halbleiterschicht (34) erstreckt.

Fig. 3 a) zeigt einen thermoelektrischen Generator mit einer stromführenden Steuerelektrode (40). Eine Stromquelle (42) und zwei auf der Steuerelektrode angebrachte Kontakte erzeugen einen Stromfluss (43) durch die Steuerelektrode (40) parallel zur flächigen Ausbildung der Halbleiterschichten (39). Durch den Stromfluss (43) in der Steuerelektrode wird ein elektromagnetisches Feld (41) um die Steuerelektrode (40) erzeugt, das sich in die Halbleiterschichten (39) erstreckt. Die Feldlinien stehen senkrecht auf der Stromflussrichtung (44) innerhalb der Halbleiterschichten des thermoelektrischen Generators.

Fig. 3 b) zeigt eine plattenförmige Elektrode (47) mit positiver Steuerspannung und das sich im Raum um die Elektrode (47) aufbauende elektrische Feld (48). Die Feldlinien stehen senkrecht auf der Oberfläche der Elektrode (47); die Äquipotentiallinien verlaufen parallel zur Oberfläche der Elektrode.

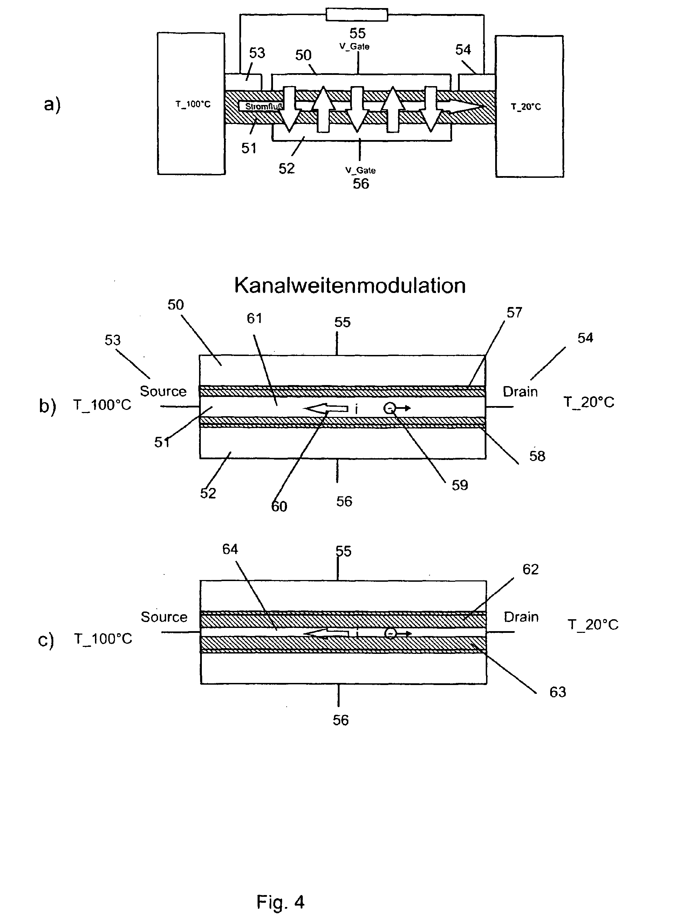

Fig. 4 a) zeigt einen thermoelektrischen Generator mit Steuerelektroden (55,56) und elektrischem Feld, das sich über die Halbleiterschichten (50,51,52) erstreckt. Über dem thermoelektrischen Generator liegt ein Temperaturgradient zwischen Wärmequelle und Wärmesenke an. Die thermoelektrisch generierte Spannung wird über die beiden elektrischen Kontakte (53, 54) auf der heißen bzw. kalten Seite abgegriffen. Der elektrische Kontakt (53) an der heißen Seite des thermoelektrischen Generators wird dabei im folgenden auch als Source bezeichnet, der elektrische Kontakt (54) auf der kalten Seite als Drain (54). Über die beidseitigen Steuerelektroden (55,56) wird das elektrische Feld erzeugt. Dabei kann jede Steuerelektrode sowohl aus Metall als auch aus dotiertem Hableitermaterial bestehen. Der Einfachheit halber wird im weiteren von Steuerelektroden (55,56) aus p-dotiertem Halbleitermaterial (50,52) ausgegangen, die auf einer Halbleiterschicht aus n-dotiertem Halbleitermaterial (51) aufgebracht sind.

Fig. 4 b) zeigt eine schematische Darstellung der Funktionsweise eines erfindungsgemäßen thermoelektrischen Generators. Der Generator besteht aus drei Schichten mit unterschiedlich dotierten Halbleitermaterialien (50,51,52). Ein typischer Aufbau wäre Steuerelektrode (55) aus p-dotiertem Halbleitermaterial(50), n-dotierte Halbleiterschicht (51), Steuerelektrode (56) aus p-dotiertem Halbleitermaterial(52). Zwischen den p- und n-dotierten Schichten (50,51,32,55,56) bilden sich sogenannte p-n-Übergänge (57, 58) aus, die sich durch eine Verschiebung der Ladungsträger (Löcher, Elektronen) ausbilden. Je nach verwendetem Material kommt es zu Verarmungsoder Anreicherungszonen von Ladungsträgern. Die Raumladungszonen (57, 58) hängen von der Austrittsarbeit der verwendeten Materialkombinationen ab. Der leitfähige Kanal (61) zwischen den beiden elektrischen Kontakten(53, 54) auf der heißen und kalten Seite, wird seitlich begrenzt durch die Raumladungszonen. Innerhalb dieses Kanals bewegen sich die Elektronen (59) von der heißen zur kalten Seite, wodurch ein Strom (60) erzeugt wird.

Legt man nun an die Steuerelektroden (55, 56) eine Steuerspannung an so werden, wie in Fig. 4. c) dargestellt, die p-/n- Übergänge (Raumladungszonen) (62, 63) je nach anliegender Polarität der Spannung verzerrt. Es entstehen vergrößerte Anreicherungs- und Verarmungszonen. Innerhalb des leitfähigen Kanals (64) zwischen Source und Drain kommt es zu eine Akkumulation der Ladungsträger (Elektronen) und somit zu einer deutlich erhöhten Leitfähigkeit in diesem eingeschnürten Kanal (64). Der elektrische Widerstand im leitfähigen Kanal (64) kann somit aktiv über die Steuerelektroden (55,56) beeinflusst werden.

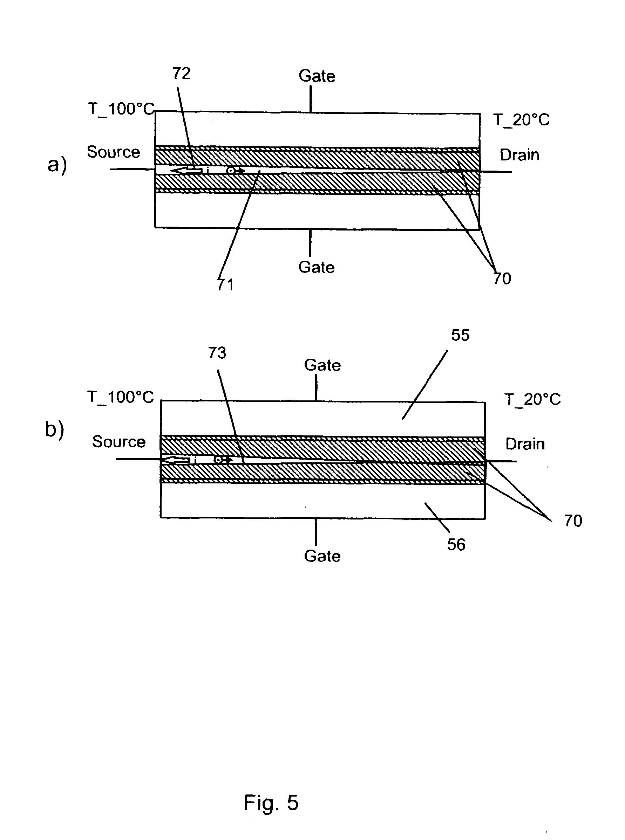

Fig. 5 a) veranschaulicht, wie durch den Stromfluss (72) zwischen Source und Drain eine asymmetrische Verzerrung der Raumladungszonen (70) entsteht. Bei erhöhtem Stromfluss wird der leitfähige Kanal (71) in der mittleren n-dotierten Halbleiterschicht spaltförmig verengt, wodurch eine Änderung der leitfähigen Kanallänge eintritt. Je nach Polarität der anliegenden Steuerspannungen können somit Anreicherungs- als auch Verarmungszonen von Ladungsträgern in der Halbleiterschicht moduliert werden. Dieser Effekt kann genutzt werden um den Weg der Elektronen im Halbleiter zu beeinflussen. Die Elektronen werden vom elektrischen Widerstand abhängig, den Weg der niedrigsten Leitfähigkeit im Material durchlaufen. Durch die Beeinflussung der Kanalgeometrie und Kanallänge kann somit der Gesamtwiderstand des thermoelektrischen Generators und der Strom- und Spannungserzeugenden Halbleiter variiert werden.

Fig. 5 b) zeigt eine schematische Darstellung eines gegenüber Fig. 5 a) verkürzten leitfähigen Kanals (73) in der n-dotierten Halbleiterschicht durch Verzerrung der Raumladungszonen (70) mittels der seitlich angeordneten Steuerelektroden (55,56).

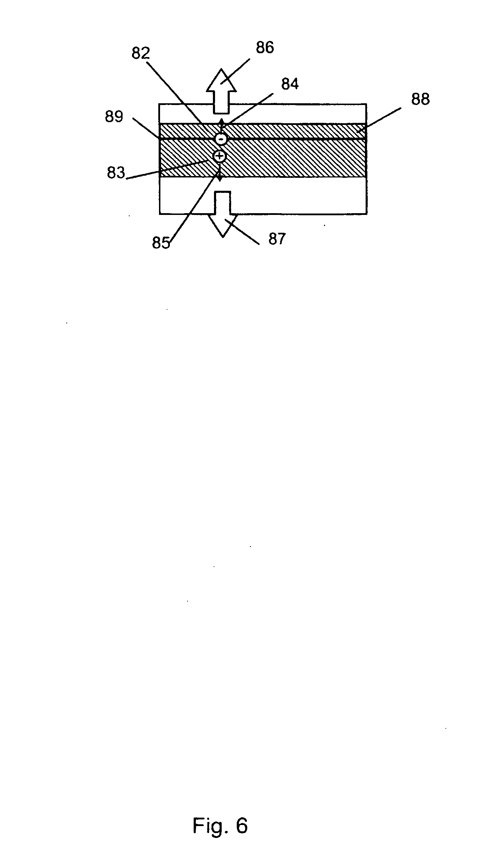

Fig. 6 a) zeigt eine schematische Darstellung der Elektron/Loch Generation in der Raumladungszone (88) (pn-Übergang (89) zwischen zwei unterschiedlich dotierten Halbleitermaterialien. Durch die Raumladungszone (88) entsteht ein elektrisches Feld, so dass elektrische Ladungsträger je nach Ladung eine unterschiedliche Kraft erfahren. In der dargestellten Raumladungszone (88) mit dem pn-Übergang (89) werden Elektronen (82) durch das elektrische Feld (86) in Richtung des Pfeils (84) bewegt. Löcher (83) driften in die entgegengesetzte Richtung (85) durch das elektrische Feld (87). Durch die Generation dieser Ladungsträger entsteht in der Raumladungszone ein thermisch generierter Strom.

**Bezugszeichenliste**

| 1 | Wärmequelle (Heizelement) |
|---|---|
| 2 | Wärmesenke (Kühlelement) |
| 3 | Substrat (Kunststoff, Metall, Keramik, Glas) |
| 4 | Halbleiterschicht |
| 5 | Steuerelektrode/Gate |
| 6 | Elektrischer Anschluss |
| 7 | elektrisch isolierende Schicht (Glas, Keramik, Oxid) |
| 8 | Stromfluß |

(fortgesetzt)

| 9 | Elektrischer Kontakt auf der heißen Seite |
| --- | --- |
| 10 | Elektrischer Kontakt auf der kalten Seite |
| 11 | Ohm'scher Verbraucher |
| 12 | Stromkreis |
| 13 | Elektrisches Feld unterhalb der Steuerelektrode |
| 14 | Stromflussrichtung (Seebeck-Effekt im Halbleitermaterial) |
| 15 | |
| 19 | elektrisch isolierende Schicht |
| 20 | Steuerelektrode |
| 21 | elektrisches Feld |
| 22 | Halbleiterschicht |
| 23 | Halbleiterschichten (p- und n-dotiert) |
| 24 | elektrisches Feld |
| 25 | Steuerelektrode |
| 26a | obere Steuerelektrode |
| 26b | untere Steuerelektrode |
| 27 | überlagertes elektrisches Feld |
| 28 | Verbindungsleitung |
| 29 | elektrischer Kontakt - kalte Seite |
| 30 | elektrischer Kontakt - heiße Seite |
| 31 | Steuerelektrode |
| 32 | Grenzfläche |
| 33 | elektrisches Feld |
| 34 | Halbleiterschicht |
| 35 | |
| 39 | Halbleiterschicht(en) |
| 40 | stromführende Steuerelektrode |
| 41 | elektromagnetisches Feld um stromführende Gate-Elektrode |
| 42 | Stromquelle |
| 43 | Stromfluss in der Steuerelektrode |
| 44 | Stromflussrichtung innerhalb der Halbleiterschicht(en) |
| 45 | |
| 47 | positiv geladene plattenförmige Elektrode |
| 48 | elektrisches Feld |
| 49 | |
| 50 | p-dotiertes Halbleitermaterial |
| 51 | n-dotierte Halbleiterschicht |
| 52 | p-dotiertes Halbleitermaterial |
| 53 | Elektrischer Kontakt heiße Seite (Source) |

(fortgesetzt)

| 54 | Elektrischer Kontakt kalte Seite (Drain) |
|----|------------------------------------------|
| 55 | Steuerelektrode oben |
| 56 | Steuerelektrode unten |
| 57 | p-/n Übergang (Raumladungszone, Verarmungszone, Anreicherungszone) |
| 58 | p-/n Übergang (Raumladungszone, Verarmungszone, Anreicherungszone) |
| 59 | Elektronen |
| 60 | strom |
| 61 | leitfähiger Kanal im n-Halbleiter |
| 62 | p-/n Übergang |
| 63 | vergrößerter p-/n Übergang |
| 64 | leitfähiger Kanal im n-Halbleiter |
| 65 | |
| 70 | p-/n Übergang (Raumladungszone, Verarmungszone, Anreicherungszone) |
| 71 | leitfähiger Kanal im n-Halbleiter |
| 72 | Stromfluss |
| 73 | leitfähiger Kanal im n-Halbleiter |
| 74 | |
| 82 | Elektron (thermisch Generiert) |
| 83 | Loch (thermisch Generiert) |
| 84 | Pfeil (Elektrondiffusion) |
| 85 | Richtung (Lochdiffusion) |
| 86 | elektrisches Feld |
| 87 | elektrisches Feld |
| 88 | Raumladungszone |
| 89 | p-/n-Übergang |
| 90 | |

**Patentansprüche**

1. Thermoelektrischer Generator mit mindestens einer ersten Leiter-Schicht (4) aus thermoelektrisch aktivem Material, einem lateralen Temperaturgradienten parallel (x-Richtung) zur Oberfläche des thermoelektrischen Materials sowie mindestens zwei selektiven Kontakten (9,10) zum Abführen des von dem Generator erzeugten Stroms, **dadurch gekennzeichnet, dass**

    - der thermoelektrische Generator Mittel zur Erzeugung eines quer zur Stromflussrichtung (14) des thermoelektrischen Generators anliegenden elektrischen Feldes (13) aufweist,
    - der thermoelektrische Generator mehrere Leiter-Schichten (23) aus thermoelektrisch aktivem Material aufweist, wobei aneinandergrenzende Leiter-Schichten unterschiedliche thermoelektrische Materialien aufweisen und das elektrische Feld (24) sich zumindest bis in die erste Leiter-Schicht hinein erstreckt und
    - dass die Mittel jeweils eine elektrisch leitfähige Steuerelektroden-Schicht (26a, 26b) umfassen, die auf beiden nach außen weisenden Oberflächen der aneinandergrenzenden Leiter-Schichten angeordnet ist.

2. Thermoelektrischer Generator nach Anspruch 1, **dadurch gekennzeichnet, dass** die Mittel eine elektrisch leitfähige Steuerelektroden-Schicht (5, 26 a) umfassen, die den überwiegenden Teil der Oberfläche der ersten Leiter-Schicht (4) aus thermoelektrisch aktivem Material abdeckt.

3. Thermcelektrischer Generator nach Anspruch 1 oder 2, **dadurch gekennzeichnet, dass** selektive Kontakte (29,30) auf verschiedenen aneinandergrenzenden Leiter-Schichten in Bereichen mit unterschiedlichen Temperaturen angeordnet sind.

4. Thermoelektrischer Generator nach Anspruch 1 oder 2, **dadurch gekennzeichnet, dass** selektive Kontakte (9,10) auf einer der Leiter-Schichten (4) in Bereichen mit unterschiedlichen Temperaturen angeordnet sind.

5. Thermoelektrischer Generator nach einem der Ansprüche 1 bis 4, **dadurch gekennzeichnet, dass** die Steuerelektroden-Schicht (31) und die angrenzende Leiter-Schicht (34) aus unterschiedlich dotierten Halbleitermaterialien bestehen, wobei eine der beiden Schichten eine p- Schicht und eine der beiden Schichten eine n-Schicht eines pn-Übergangs entlang der Grenzschicht (32) zwischen der Steuerelektroden-Schicht und der angrenzenden Leiter-Schicht ausbildet.

6. Thermoelektrischer Generator nach einem der Ansprüche 1 bis 4, **dadurch gekennzeichnet, dass** zwischen der elektrisch leitfähigen Steuerelektroden-Schicht (20) und der Leiter-Schicht (22) aus thermcelektrisch aktivem Material eine elektrisch isolierende Schicht (19) angeordnet ist.

7. Thermoelektrischer Generator nach einem der Ansprüche 1 bis 6, **dadurch gekennzeichnet, dass** an der Steuerelektroden-Schicht (40) zwei Kontakte zu deren Stromversorgung derart angeordnet sind, dass ein Stromfluss (43) in der Steuerelektroden-Schicht (40) parallel zur Stromflussrichtung (44) des thermoelektrischen Generators erzeugt wird.

8. Thermoelektrischer Generator nach einem der Ansprüche 1-7, **dadurch gekennzeichnet, dass** die Steuerelektrode aus einzelnen schichtförmigen Segmenten besteht und sich leitfähige und nichtleitfähige Segmente auf der Oberfläche des thermoelektrischen Materials abwechseln.

**Claims**

1. Thermoelectric generator comprising at least one first conductor layer (4) made of thermoelectrically active material, a lateral temperature gradient parallel (x direction) to the surface of the thermoelectric material as well as at least two selective contacts (9, 10) for removing the current produced by the generator, **characterised in that**

   - the thermoelectric generator comprises means for generating an electric field (13) applied transversely to the current flow direction (14) of the thermoelectric generator,
   - the thermoelectric generator comprises a plurality of conductor layers (23) made of thermoelectrically active material, wherein adjacent conductor layers comprise different thermoelectric materials and the electric field (24) extends at least as far as into the first conductor layer and
   - that the means each comprise an electrically conductive control electrode layer (26a, 26b) which is disposed on both outwardly pointing surfaces of the adjacent conductor layers.

2. The thermoelectric generator according to claim 1, **characterised in that** the means comprises an electrically conductive control electrode layer (5, 26a) which covers the predominant part of the surface of the first conductor layer (4) made of thermoelectrically active material.

3. The thermoelectric generator according to claim 1 or 2, **characterised in that** the selective contacts (29, 30) are disposed on different adjoining conductor layers in regions having different temperatures.

4. The thermoelectric generator according to claim 1 or 2, **characterised in that** selective contacts (9, 10) are disposed on one of the conductor layers (4) in regions having different temperatures.

5. The thermoelectric generator according to any one of claims 1 to 4, **characterised in that** the control electrode layer (31) and the adjacent conductor layer (34) consist of differently doped semiconductor materials, wherein one of the two layers forms a player and one of the two layers forms an n-layer of a pn junction along the boundary layer (32) between the control electrode layer and the adjoining conductor layer.

**6.** The thermoelectric generator according to any one of claims 1 to 4, **characterised in that** an electrically insulating layer (19) is disposed between the electrically conductive control electrode layer (20) and the conductor layer (22) made of thermoelectrically active material.

**7.** The thermoelectric generator according to any one of claims 1 to 6, **characterised in that** on the control electrode layer (40) two contacts to the power supply thereof are disposed in such a manner that a current flow (43) in the control electrode layer (40) is produced parallel to the current flow direction (44) of the thermoelectric generator.

**8.** The thermoelectric generator according to any one of claims 1 to 7, **characterised in that** the control electrode consists of single layer-shaped segments and conductive and non-conductive segments alternate on the surface of the thermoelectric material.

### Revendications

**1.** Générateur thermoélectrique avec au moins une première couche de conducteurs (4) en matière thermoélectrique active, un gradient thermique latéral parallèle (direction x) à la surface de la matière thermoélectrique, ainsi qu'au moins deux contacts (9, 10) sélectifs pour évacuer le courant généré par le générateur, **caractérisé en ce que**

- le générateur thermoélectrique comporte des moyens pour générer un champ électrique (13) appliqué à la transversale de la direction du flux de courant (14) du générateur thermoélectrique,
- le générateur thermoélectrique comporte plusieurs couches de conducteurs (23) en matière thermoélectrique active, des couches adjacentes de conducteurs comportant différentes matières thermoélectriques et le champ électrique (24) s'étendant au moins jusque dans la première couche de conducteurs et
- **en ce que** les moyens comprennent chacun une couche conductrice d'électrodes de commande (26a, 26b) qui est disposée sur les deux surfaces dirigées vers l'extérieur des couches adjacentes de conducteurs.

**2.** Générateur thermoélectrique selon la revendication 1, **caractérisé en ce que** les moyens comprennent une couche conductrice d'électricité d'électrodes de commande (5, 26 a) qui recouvre la majeure partie de la surface de la première couche de conducteurs (4) en matière thermoélectrique active.

**3.** Générateur thermoélectrique selon la revendication 1 ou la revendication 2, **caractérisé en ce que** des contacts (29, 30) sélectifs sont disposés sur différentes couches adjacentes de conducteurs, dans des zones présentant différentes températures.

**4.** Générateur thermoélectrique selon la revendication 1 ou la revendication 2, **caractérisé en ce que** des contacts (9, 10) sélectifs sont disposés sur l'une des couches de conducteurs (4), dans des zones présentant différentes températures.

**5.** Générateur thermoélectrique selon l'une quelconque des revendications 1 à 4, **caractérisé en ce que** la couche d'électrodes de commande (31) et la couche adjacente de conducteurs (34) sont constituées de matières semiconductrices à dopages différents, l'une des deux couches formant une couche p et l'une des deux couches formant une couche n d'une transition pn le long de la couche limite (32) entre la couche d'électrodes de commande et la couche adjacente de conducteurs.

**6.** Générateur thermoélectrique selon l'une quelconque des revendications 1 à 4, **caractérisé en ce qu'**entre la couche d'électrodes de commande (20) conductrices d'électricité et la couche de conducteurs (22) en matière thermoélectrique active est disposée une couche (19) isolante électrique.

**7.** Générateur thermoélectrique selon l'une quelconque des revendications 1 à 6, **caractérisé en ce que** sur la couche d'électrodes de commande (40), deux contacts pour son alimentation électrique sont disposés de telle sorte qu'un flux de courant (43) dans la couche d'électrodes de commande (40) soit généré à la parallèle de la direction du flux de courant (44) du générateur thermoélectrique.

**8.** Générateur thermoélectrique selon l'une quelconque des revendications 1 à 7, **caractérisé en ce que** l'électrode de commande est constituée de segments individuels en forme de couches et **en ce que** des segments conducteurs et non-conducteurs s'alternent sur la surface de la matière thermoélectrique.

a)

1

11

12

9 6 5 10

V_Gate

T_100°C

2

T_20°C

3 8 7 4

y

z

x

b)

1

11

2

V_Gate

T_100°C

Stromfluß

elektrisches Feld

T_20°C

14 13

Fig. 1

Fig. 2

a)

T_100°C

V_Gate

T_20°C

42   41   40   39

43   44

b)

47

48

Fig. 3

a)

T_100°C  53  50  55  54  T_20°C
V_Gate
51  Stromfluß
52
V_Gate
56

## Kanalweitenmodulation

50  61  55  57
53  54
b)  T_100°C  Source  Drain  T_20°C
51
52  i
60  56  59  58

64  55
62
c)  T_100°C  Source  Drain  T_20°C
i
56  63

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1287566 B1

**In der Beschreibung aufgeführte Nicht-Patentliteratur**

- *Journal of Applied Physics,* 2001, vol. 90 (5), 2370-2379